# EUROPEAN PATENT SPECIFICATION

(11) **EP 4 013 198 B1**
(45) Date of publication and mention of the grant of the patent: **14.10.2026**
(21) Application number: 21213795.4
(22) Date of filing: 10.12.2021
(51) Int. Cl.: H05K 5/02

(54) **RETAINER FOR A MANIFOLD**
HALTERUNG FÜR EINEN VERTEILER
DISPOSITIF DE RETENUE POUR UN COLLECTEUR

(30) Priority: 11.12.2020 US 202063124216 P
(43) Date of publication of application: 15.06.2022
(73) Proprietor: Hoffman Enclosures, Inc., Anoka, MN 55303 (US)
(72) Inventor: DeMars, Allen, Elk River, 55330 (US)
(74) Representative: Barker Brettell LLP

(56) References cited:
- EP-A1- 3 668 285
- US-A- 3 219 157
- US-A- 690 277
- US-A1- 2007 132 224
- US-A1- 2012 255 709
- US-A1- 2020 163 251
- US-B2- 9 161 465

## Description

### BACKGROUND

In some cooling system applications, a manifold may deliver flows of cooling fluid to and from electronics supported on a rack within a cabinet or stack. The manifold can be attached to a mounting structure, which can include the rack. During shipment, installation, or use, a secured connection between the manifold and the mounting structure can be important.

US 2020/163251 A1 relates to a network communications device, including a chassis, a plurality of modules removably inserted into a plurality of slots in the chassis, at least a portion of the modules each comprising a connector for receiving coolant for cooling components on the module, a controller for controlling coolant distribution to the modules, and a leak detection system for identifying a leak of the coolant and transmitting an indication of the leak to the controller. [0001b] US 2007/132224 A1 relates to a seat belt anchor device and a method for anchoring a seat belt to a stud. The device includes a plate member having a keyhole opening into which the stud is fit with the plate member pulled upwardly to bring the stud to the installed position relative to the plate member. A spring retainer member keeps the stud and plate member in their installed position. A stop is provided to limit pivoting of the spring retainer member relative to the plate member. In some forms, the spring retainer includes resilient clamping portions for clamping engagement with the stud head therebetween in the installed portion.

EP 3 668 285 A1 relates to a system for releasably connecting a first device housing with a second device housing. The system comprises at least three connection units, wherein each of the connection units comprises a headed bolt and a corresponding keyhole-shaped recess. The keyhole-shaped recess is configured for receiving the headed bolt in such a manner that the headed bolt can be inserted into the recess in a first section and held in the recess in a second section. At least one of the connection units comprises a locking mechanism configured for locking the bolt in the second section of the recess. The locking mechanism comprises a movable locking element which is movable with respect to the headed bolt and configured to hold the headed bolt in the second section of the recess in a locking position. Alternatively, the locking mechanism comprises a flexible buffer element arranged in the second section of the keyhole-shaped recess, which is configured to load the headed bolt with a frictional force to hold the headed bolt in the second section of the recess in a locking position. Furthermore, a corresponding connection arrangement is provided that includes such a system.

### SUMMARY

In an example of the disclosure there is provided a retainer for securing a manifold, with a mounting feature, to a mounting structure, with a keyhole slot. The retainer can include a body having a first end and a second end opposite the first end. The body can be configured to be affixed to the mounting structure at the second end and can define a flex axis at the affixation location. An aperture can be provided in the first end of the body. The aperture can be configured to be positioned adjacent a retention portion of the keyhole slot. The body can be configured to flex away from the mounting structure about the flex axis upon contact with the mounting feature, when the mounting feature extends through a receiving portion of the keyhole slot, and can rebound when the mounting feature is further received within the retention portion of the keyhole slot, so that the mounting feature is captured within the aperture.

In an example of the disclosure, there is provided a retainer assembly for securing a manifold to a mounting structure. The retainer assembly can include a retainer having a body. The body can have a first end, a second end opposite the first end, and an aperture in the first end. The body can be configured to be affixed to the mounting structure at the second end so that the aperture is positioned adjacent a retention portion of a keyhole slot in the mounting structure. The retainer assembly can further include a bushing with a groove and a bore. The bore can extend along a bushing axis and can be configured to receive a stud extending from the manifold. The body can be configured to flex away from the mounting structure upon contact with the bushing, when the bushing extends through a receiving portion of the keyhole slot, and can rebound when the retention portion of the keyhole slot is received within the groove of the bushing, so that the bushing is captured within the aperture.

In an example of the disclosure, there is provided a method for securing a connection between a manifold, with a spool bushing mounted thereto, and a mounting structure, with a keyhole slot. The method can include inserting the spool bushing into the keyhole slot. The spool bushing can contact and thereby flex a retainer affixed to the mounting structure. The method can further include sliding the spool bushing along the keyhole slot to engage the spool bushing with the mounting structure and captivating the spool bushing within an aperture in the retainer.

According to a first aspect of the invention, there is provided a manifold system for a colling system as defined in claim 1. Optional and/or preferable features are defined in the dependent claims.

In an embodiment, the retention plate is flush with and parallel to the mounting structure, on an opposite side of the mounting structure from the manifold, when the retention plate is in the retention configuration to capture the mounting protrusion in the keyhole slot.

In an embodiment, a release tab extends from the retention plate through a mounting structure toward a manifold, the release tab being placed to be urged toward the mounting structure to flex the retention plate to a release configuration.

In an embodiment, a release tab has a form-stop configured to contact a mounting structure when the retention plate has flexed to or past a release configuration.

In an embodiment, a first end of the retention plate has a first-end width measured along a direction of a flex axis, and the first end of the retention plate includes a notch with a notch width measured along the direction of the flex axis. In some cases, the notch width can be in a range of about 25 percent to about 75 percent of the first-end width.

In an embodiment, a first part of a retention plate that does not include an aperture to capture a mounting protrusion is aligned with a receiving portion of a keyhole slot when the retention plate is in a retention configuration. In some cases, a mounting structure includes a release aperture, and a second part of a retention plate that does not include the aperture is aligned with the release aperture so that the retention plate is arranged to be flexed to the release configuration by contact with a tool inserted through the release aperture.

In an example of the disclosure, there is provided a manifold system for securing a manifold of a cooling system to a mounting structure. A mounting structure can have a slot having a first portion and a second portion that is narrower than the first portion. A retainer can have a retainer body, the retainer body having a first end, a second end opposite the first end, and an aperture in the first end. The second end of the retainer body can be affixed to the mounting structure so that the aperture is positioned adjacent the second portion of the slot. A bushing can have a major diameter and a groove with a minor diameter, can extend along a bushing axis and can be configured to be secured to the manifold to extend away from the manifold to be received through the keyhole slot. The major diameter can be sized to be received in the first portion of the slot but not in the second portion of the slot, and the minor diameter can be sized to be received in the first and second portions of the slot. The retainer body can be configured to be deflected away from the mounting structure upon contact with the bushing, when the bushing extends through the first portion of the slot, and to rebound to receive the bushing in the aperture and thereby capture the bushing within the slot when the groove of the bushing is slid into the second portion of the slot.

A groove in the bushing can have a proximal sidewall and a distal sidewall, the distal sidewall disposed at an oblique angle relative to the proximal sidewall.

The bushing can be a polymeric bushing and can include a bore that is configured to receive a threaded stud of the manifold.

A bore of a bushing can have a bore length and can be threaded along a first portion of the bore length and not threaded along a second portion of the bore length. The first portion may extend about 70 percent of the bore length.

In an example of the disclosure, a release tab can extend from an edge of a retainer body at the first end of the retainer body and can extend through a hole in a mounting structure to protrude from the mounting structure on a same side of the mounting structure as a manifold, the release tab being thus located to be urged toward the mounting structure to flex the first end of the retainer body away from the mounting structure. In some cases, the release tab can extend as a bent component with a free end configured to contact the mounting structure when the retainer body has flexed a predetermined distance. In some cases, the release tab can be integral with the retainer body.

A retainer can include a notch that extends into a body of the retainer at a second end thereof, between a first location and a second location at which the retainer body is affixed to the mounting structure. In some cases, the notch can extend past the first and second locations, in a direction extending from the second end of the retainer body toward the first end of the retainer body.

A mounting structure can include a release aperture, and a solid portion of a second end of a retainer body can at least partly overlap with the release aperture, the retainer body being thereby adapted to be configured to be engaged via the release aperture to be deflected away from the mounting structure.

According to a second aspect of the invention, there is provided a method for mounting or demounting a manifold as defined in claim 11. Optional and/or preferable features are defined in the dependent claims.

In an embodiment, the method can include, with a mounting protrusion retained in a retention portion of a keyhole slot, manually engaging a retention plate to deflect a first end of the retention plate away from a mounting structure and thereby remove the mounting protrusion from an aperture in the second end of the retention plate. With the second end of the retention plate deflected away from the mounting structure, a manifold assembly can be moved along the mounting structure in the direction opposite a seating direction to move the mounting protrusion to a receiving portion of the keyhole slot. The manifold assembly can be moved away from the mounting structure, in a direction opposite the axial insertion direction, to remove the mounting protrusion from the receiving portion of the keyhole slot.

Features which are described in the context of separate aspects and/or embodiments of the invention may be used together and/or be interchangeable wherever possible. Similarly, where features are, for brevity, described in the context of a single embodiment, those features may also be provided separately or in any suitable sub-combination. Features described in connection with the system may have corresponding features definable and/or combinable with respect to a method or vice versa, and these embodiments are specifically envisaged.

### BRIEF DESCRIPTION OF THE DRAWINGS

Various embodiments and examples are shown and discussed herein, to be construed in as much as they fall within the scope of the appended claims.

The accompanying drawings, which are incorporated in and form a part of this specification, illustrate embodiments of the invention and, together with the description, serve to explain the principles of embodiments of the invention:
FIG. 1 is a front elevation partial view of a manifold assembly according to an embodiment of the invention, with a retainer according to an embodiment of the invention affixed to a mounting bracket and in a flexed state via contact with a mounting protrusion of a manifold;
FIG. 2 is a side elevation partial view of the assembly of FIG. 1
FIGS. 3, 4 and 5 are a front elevation, side elevation, and rear isometric views, respectively, of the assembly of FIG. 1, with the retainer in a flexed state and the mounting protrusion captured by the retainer, and with the mounting bracket shown as transparent in FIG. 5;
FIG. 6 is a side elevation view of an example mounting protrusion for the manifold of FIG. 1, configured as a spool bushing;
FIG. 7 is a cross-sectional view of the spool bushing of FIG. 6 captured by the retainer of FIG. 1; and
FIGS. 8A and 8B show operations for removing a manifold from a mounting structure (or, in reverse, for attaching the manifold to the mounting structure).

### DETAILED DESCRIPTION

Before any embodiments of the invention are explained in detail, it is to be understood that the invention is not limited in its application to the details of construction and the arrangement of components set forth in the following description or illustrated in the following drawings, within the scope of the appended claims. The invention is capable of other embodiments and of being practiced or of being carried out in various ways, again in as much as it is defined by the claims. Also, it is to be understood that the phraseology and terminology used herein is for the purpose of description and should not be regarded as limiting. The use of "including," "comprising," or "having" and variations thereof herein is meant to encompass the items listed thereafter and equivalents thereof as well as additional items. Unless specified or limited otherwise, the terms "mounted," "connected," "supported," and "coupled" and variations thereof are used broadly and encompass both direct and indirect mountings, connections, supports, and couplings. Further, "connected" and "coupled" are not restricted to physical or mechanical connections or couplings.

Also as used herein, unless otherwise limited or defined, "or" indicates a non-exclusive list of components or operations that can be present in any variety of combinations, rather than an exclusive list of components that can be present only as alternatives to each other. For example, a list of "A, B, or C" indicates options of: A; B; C; A and B; A and C; B and C; and A, B, and C. Correspondingly, the term "or" as used herein is intended to indicate exclusive alternatives only when preceded by terms of exclusivity, such as "either," "one of," "only one of," or "exactly one of." For example, a list of "one of A, B, or C" indicates options of: A, but not B and C; B, but not A and C; and C, but not A and B. A list preceded by "one or more" (and variations thereon) and including "or" to separate listed elements indicates options of one or more of any or all of the listed elements. For example, the phrases "one or more of A, B, or C" and "at least one of A, B, or C" indicate options of: one or more A; one or more B; one or more C; one or more A and one or more B; one or more B and one or more C; one or more A and one or more C; and one or more of A, one or more of B, and one or more of C. Similarly, a list preceded by "a plurality of" (and variations thereon) and including "or" to separate listed elements indicates options of multiple instances of any or all of the listed elements. For example, the phrases "a plurality of A, B, or C" and "two or more of A, B, or C" indicate options of: A and B; B and C; A and C; and A, B, and C.

Also as used herein, unless otherwise limited or defined, the terms "about" and "approximately" refer to a range of values ± 5% of the numeric value that the term precedes. As a default the terms "about" and "approximately" are inclusive to the endpoints of the relevant range, but disclosure of ranges exclusive to the endpoints is also intended.

Also as used herein, unless otherwise limited or defined, "integral" and derivatives thereof (e.g., "integrally") describe elements that are manufactured as a single piece without fasteners, adhesive, or the like to secure separate components together. For example, an element stamped as a single-piece component from a single piece of sheet metal, without rivets, screws, or adhesive to hold separately formed pieces together is an integral (and integrally formed) element. In contrast, an element formed from multiple pieces that are separately formed initially, then later connected together, is not an integral (or integrally formed) element.

The following discussion is presented to enable a person skilled in the art to make and use embodiments of the invention. Various modifications to the illustrated embodiments will be readily apparent to those skilled in the art, and the generic principles herein can be applied to other embodiments and applications without departing from embodiments of the invention, so long as they fall within the scope of the claims. The following detailed description is to be read with reference to the figures, in which like elements in different figures have like reference numerals. The figures, which are not necessarily to scale, depict selected embodiments and are not intended to limit the scope of embodiments of the invention.

Some of the discussion below describes a retainer that can be used to help secure a manifold of a fluid distribution system (e.g., a liquid cooling system for servers or other electronics) to a mounting structure. For example, as detailed below, some embodiments of a retainer according to the invention can be used to secure manifolds for high density liquid cooling systems to support members within or near enclosures, to position the manifold to provide or receive cooling liquid flows for adjacent server racks. However, the context and particulars of this discussion are presented as examples only and some embodiments can be similarly employed in other systems.

In some embodiments, a retainer according to the invention can increase stability and security of attachment during transportation of a manifold and a mounting structure (e.g., when the manifold is attached to the mounting structure at a remote location then shipped to an operational installation). In some embodiments, a retainer according to the invention can also provide increased stability and security during installation of a manifold in a server rack assembly and also during operation of the associated liquid cooling (or other) system.

For example, when manifolds are shipped along with the associated mounting structures to be used in a server rack assembly, they are generally shipped connected. It is useful to ensure that this connection is maintained during shipment, including to improve installation times at operational installations. Further, if a manifold becomes disconnected from a mounting structure during shipment, relative movement of the parts may cause not only cosmetic damage but also functional damage.

Conventional arrangements for securing connections between manifolds and mounting structures include attaching zip ties or wire. Although this approach can be useful, it requires additional labor and material to ready assemblies for shipment, and additional labor and waste to remove the ties prior to installation. There is also the potential for these ancillary ties to permit some movement during shipping or installation, and thus cause at least cosmetic damage to the relevant manifolds or mounting structures.

Ensuring a secure connection between a manifold and a mounting structure can also be beneficial in other contexts. For example, whether a manifold and a mounting structure are shipped separately or assembled together, it may be useful to ensure a secure connection between the manifold and the mounting structure during installation and operation of the relevant system.

Embodiments of the invention can address these or other issues by helping to ensure a secure connection between a manifold and a mounting structure. In particular, in some embodiments, a retainer can include a flexible member that can be secured to a larger support structure so that an opening in the flexible member is in partial alignment with an opening in the support structure that provides an attachment point for a manifold. With the retainer thus aligned, installation of the manifold can include moving a mounting protrusion of the manifold (e.g., a separately manufactured bushing) into the opening on the support structure and thereby flexing the flexible member (including the opening therein) to a release configuration. Subsequently moving the manifold to an installed orientation can then permit the flexible member to resiliently return from the release configuration to a retention configuration, so that the mounting protrusion is captured by the opening in the flexible member and thereby prevented from being removed from the opening in the mounting structure. Thus, via resilient movement of the flexible member during installation of the manifold, the manifold can be automatically secured by the flexible member against removal from the mounting structure.

In some embodiments, a resiliently flexible retainer (e.g., a metal or composite plate) can be affixed to the mounting structure with an aperture of the retainer in alignment with (e.g., fully overlapping with, along an insertion direction) a narrower, retention portion of a keyhole slot of the mounting structure. Further, the aperture can be out of alignment with (e.g., not overlapping with at least part of, along the insertion direction) a wider, receiving portion of the keyhole slot. When a mounting feature (e.g., a fastener) on the manifold is initially inserted through the receiving portion of the keyhole slot in the insertion direction, the mounting feature can thus be out of alignment with the aperture of the retainer and can accordingly displace the retainer away from the mounting structure. Thereafter, moving the mounting feature into the retention portion of the keyhole slot can align the mounting feature to be received through the aperture on the retainer. This can allow the retainer to resiliently move back toward the mounting structure so that the mounting feature extends into and is captured within the aperture on the retainer and the retainer thereby prevents the mounting structure from moving back into the receiving portion of the keyhole slot.

In some embodiments, the retainer can be engaged during the connection of the manifold to the mounting structure, requiring no additional labor to secure the connection between the manifold and the mounting structure. In some cases, mounting features on a manifold can include protrusions extending from a wall on the manifold. For example, a spool bushing or other fastener or boss can be attached to the manifold and can be sized to be received and engaged within a keyhole slot in the mounting structure. The retainer can then capture the spool bushing within an aperture sized to receive the spool bushing, which can be aligned with a portion of the keyhole slot in which the spool bushing is located when the manifold is fully installed (i.e., when a final operational connection is provided between the manifold and the mounting structure).

In some embodiments, the retainer can be formed from a resilient material (e.g., spring steel), so that during the installation of the manifold onto the mounting structure the spool bushing can contact the retainer when it is inserted into the keyhole slot and can resiliently flex the retainer away from the mounting structure. This can allow the spool bushing to move relatively freely within the keyhole slot until, once the spool bushing is seated and aligned with the aperture, the retainer rebounds to capture the spool bushing within the aperture and prohibit movement of the spool bushing within the keyhole slot.

In some cases, a retainer can include a release tab that can be engaged to flex the retainer away from the mounting structure to release (or "decapture") a spool bushing (or other mounting feature) and thereby permit the disconnection of the manifold from the mounting structure. In some embodiments, a release feature can include a hole in the mounting structure allowing a tool to be inserted therethrough, to abut the retainer and, with an applied force, flex the retainer away from the mounting structure to decapture a spool bushing (or other mounting feature).

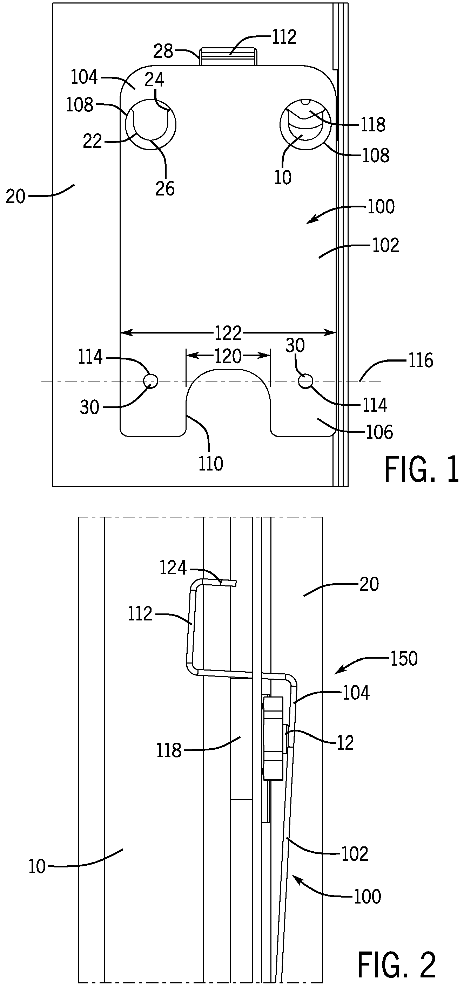

FIGS. 1-5 illustrate an example retainer 100 in an example retainer assembly 150, according to an embodiment of an invention, in the context of a manifold 10 for delivering liquid to or from a server rack assembly (not shown) to remove heat from electrical equipment (not shown) of various known configurations. In particular, the retainer 100 is arranged to secure the attachment of the manifold 10 to a mounting structure 20 to provide a server assembly with notably secure attachment connections for transport, installation in a larger cooling system, and operation of the cooling system. Generally, the mounting structure 20 can be a structure that is mountable to a server rack assembly or a structural piece of a server rack assembly, as can support the manifold structure 20 relative to a larger installation.

Generally, a retainer can be formed as a flexible body with an elastic response within an intended range of motion. Further, a retainer can generally be secured to a mounting structure so as to be able to be flexed away from the mounting structure by an external force and then resiliently move back toward the mounting structure when the force is removed. In the illustrated example, the retainer 100 has a body 102, formed as an integral plate with an end 104 (e.g., a first end) and an end 106 (e.g., a second end) opposite the end 104. Although only a single instance of the retainer 100 is shown, in some embodiments more than one retainer (e.g., multiple instances of the retainer 100) can be affixed to a mounting structure to secure additional attachment of the manifold 10 to the mounting structure 20 at multiple locations.

Continuing with regard to FIGS. 1 through 4, the retainer 100 is configured to be securely (e.g., non-removably) affixed to the mounting structure 20 with an end still remaining free to flex away from the mounting structure 20. In particular, the end 106 of the retainer 100 can be mounted to the mounting structure 20, as shown in FIG. 1, with a set of rivets 30 (or other fasteners) at affixation locations 114. Other fasteners for affixing the retainer 100 to the mounting structure 20 are also contemplated. For example, the retainer 100 can be affixed using bolts or screws. Further, although the two affixation locations 114 for the retainer 100 may provide an optimally secure attachment, other configurations are possible.

As also noted above, retainers according to the invention are generally configured to be sufficiently elastic to be able to flex repeatedly away from (and then resiliently back towards) a mounting structure. In the illustrated embodiment, the affixation locations 114, at which the set of rivets 30 affix the retainer 100 to the mounting structure 20, defines a flex axis 116 extending laterally across the end 106 of the body 102. The end 104 of the body 102 is thus configured to flex or bend relative to the end 106 - and the mounting structure 20 - about the flex axis 116, with additional bending along the length of the body 102 according to generally known principles of mechanics and materials.

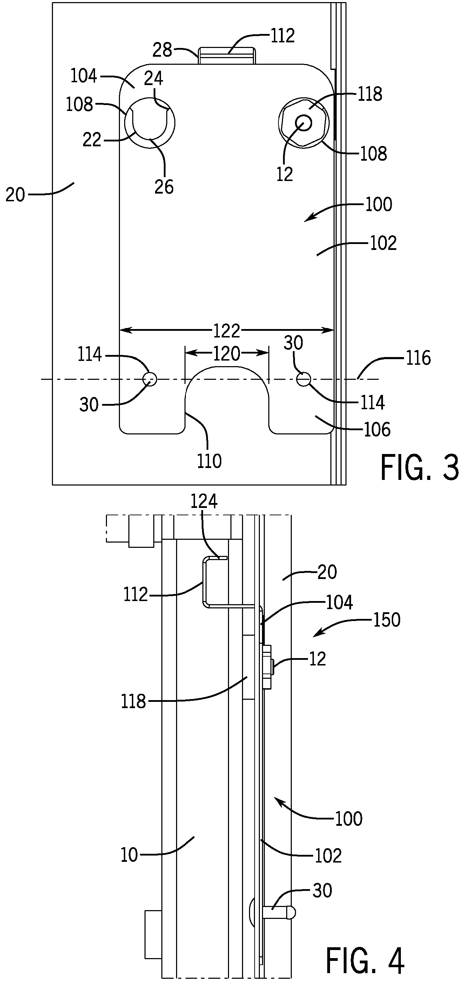

Relatedly, the body 102 can be made from a resilient, but pliable material such as an appropriate gauge of spring steel, or another appropriate material, to enable a resilient response throughout the range and frequency of the necessary bending. For example, the retainer 100 is formed as a stamped spring steel plate that is sufficiently thin so as to be readily moved from a rest state, as shown in the retention configuration of FIGS. 3 and 4, to a flexed state as shown in the installation configuration FIGS. 1 and 2, by a manually applied force during installation (or removal) of the manifold 10.

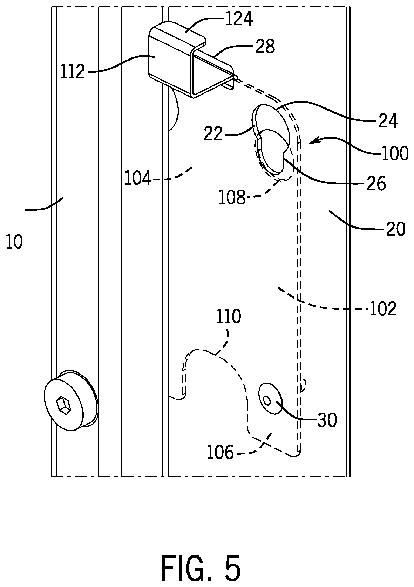

Generally, retainers according to the invention can include one or more apertures arranged to be flexed with the retainer body away from a mounting structure. Further, a retainer can be installed on a corresponding mounting structure so that the one or more apertures on the retainer is aligned with a retention portion of an aperture in a mounting structure for securing a manifold (e.g., is arrayed along a common insertion axis with at least part of the aperture on the mounting structure). For example, two apertures 108 are formed as fully enclosed (e.g., circular) holes in the end 104 of the body 102. When attached to the mounting structure 20, each of the two apertures 108 can be aligned with a narrower retention portion 26 at the end of a corresponding keyhole slot 22 in the mounting structure 20, as shown in FIGS. 1 and 5 in particular (e.g., aligned so that a central, centroid or other through-axis for the retention portion 26 of the slot 22 is coaxial with a central, centroid or other through-axis for the aperture 108). Further, each of the two apertures 108 can be partly misaligned with a wider receiving portion 24 at an opposing end of the slot 22 (e.g., aligned so that at least part of the solid form of the body 102 adjacent to the apertures 108 overlaps with the receiving portion 24).

The aperture 108 can be sized to receive and thereby capture a mounting feature (e.g., a spool bushing 118 or other protrusion or fastener) that extends from the manifold 10, as discussed further below and shown in FIGS. 3 and 4, when the retainer 100 is in a retention configuration (e.g., as shown in FIG. 3). Thus, for example, due to the misalignment of the apertures 108 and the receiving portions 24, when the spool bushing 118 is inserted into the receiving portion 24 of the keyhole slot 22 as shown in FIGS. 1 and 2, the bushing 118 contacts the body 102 of the retainer 100 to flex the end 104 of the retainer away from the mounting structure 20. The bushing 118 can thus be sufficiently received into the keyhole slot 22 in an axial insertion direction so that the bushing 118 can be slid into the retention portion 26 of the keyhole slot 22, with corresponding movement of the manifold 10 to an installed configuration. Due to the alignment of the apertures 108 with the retention portions 26 of the keyhole slots 22, the body 102 can then resiliently return to a retention configuration, as shown in FIGS. 3 and 4, with the bushing 118 thus received into the corresponding aperture 108 and thereby prevented from moving back to the receiving portion 24 of the keyhole slot 22 for removal of the bushing 118 from the slot 22 (and removal of the manifold 10 from the mounting structure 20).

In some cases, the inclusion of multiple apertures on a retainer can allow multiple manifolds to be secured by a single retainer or can allow a manifold to be secured at multiple locations by a single retainer. However, in some embodiments, a different number of apertures can be provided in a body of a retainer. For example, only a single aperture can be provided in some cases, or one or more additional apertures can provide one or more additional locations for securing a manifold.

In some embodiments, a retainer can include features to provide desired bending characteristics. Looking again at FIG. 1, for example, the retainer 100 includes a notch 110 in the end 106 of the body 102. The notch 110 extends into the body 102 from a lower edge of the end 106 toward the end 104, with a notch width 120 defined along the flex axis 116. Further, the notch 110 generally terminates at or near (e.g., extends across) the flex axis 116. The notch 110 has a notch width 120 defined along the flex axis 116. The dimensional relationship between the notch width 120 and a second end width 122 of the body 102 along the flex axis 116, can at least partly define the flexibility of the retainer 100. For example, the more the notch width 120 is increased relative to the second end width 122, the more flexible the retainer 100 will tend to be (with other characteristics remaining equal). In some embodiments, the notch width 120 is in the range of about 25 percent to about 75 percent of the second end width 122, as can allow for sufficient capturing strength and resilience for proper operation of the retainer 100, while still allowing manual flexing of the retainer 100 by an average worker. In some embodiments, however, it is contemplated that a retainer may not have a notch or may have a notch that is differently configured than the notch 110 (e.g., differently sized, shaped, or located).

In some embodiments, a retainer can include a release feature that can be used to bend the retainer to release a captured mounting feature of a manifold. For example, the retainer 100 includes a release tab 112, as show in FIGS. 2 and 4 in particular. Generally, a release tab can be configured to extend from a retainer body and through or around a wall of a mounting structure to which the retainer body is mounted. Thus configured, a release tab can provide an interface for actuating the release tab from a side of the mounting structure that is opposite to a side of the mounting structure on which the body is located (e.g., from the same side on which a manifold is disposed). In the illustrated embodiment, the release tab 112 extends from the end 104 perpendicular to a plane defined by the body 102 and extends through a hole 28 in the mounting structure 20 (see FIGS. 3 and 5) in the direction of the manifold 10. The release tab 112 is thus arranged to be urged in the direction of the mounting structure 20, by force applied from the same side of the mounting structure 20 as the manifold 10, to flex the end 104 of the body 102 away from the mounting structure 20 so that the retainer 100 decaptures the spool bushing 118.

In some cases, a retainer may include a stop that can prevent the retainer from being flexed excessively away from a retention position. In the illustrated embodiment, the release tab 112 has a form-stop 124 configured to limit the travel of the release tab 112. The form-stop 124 can abut the mounting structure 20 when the end 104 of the body 102 is flexed to a point where the aperture 108 is no longer captivating the spool bushing 118, thereby providing tactile feedback to indicate that the spool bushing 118 can be removed from the keyhole slot 22. The form-stop 124 can also prevent the release tab 112 from traveling entirely though the hole 28 in the mounting structure, such as might result in the retainer 100 being trapped in a deformed configuration. The form-stop 124 may also reduce the likelihood that the body 102 will be plastically deformed from flexing too far while being urged away from the mounting structure 20. In some embodiments, the release tab 112 can be replaced or supplemented with another form of a release (not shown), including releases requiring activation with a special or general purpose tool. For example, another form of the release can include a specially shaped hole (not shown) through which only a special tool can be received, so that only those with access to a particular tool can easily urge the end 104 further away from the mounting structure 20 to decapture the spool bushing 118 and remove the manifold 10.

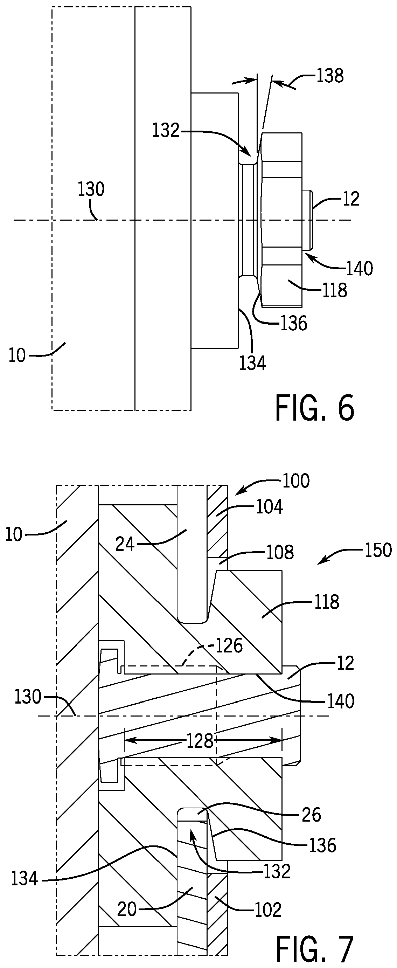

In some embodiments, specialized mounting features (e.g., specifically contoured protrusions) can provide further benefits. For example, as shown in FIGS. 6 and 7 in particular, the spool bushing has a bore 140 with a bore length 128 that extends along a bushing axis 130. The bore 140 is configured to receive a stud 12 extending from the manifold 10. The spool bushing 118 can thereby be secured to the manifold 10 through a threaded engagement between the stud 12 and a threaded portion 126 of the bore 140.

In some embodiments the spool bushing 118 can be polymeric. For example, the thermal properties of a spool bushing 118 formed of appropriate polymers can provide a thermally insulative barrier between the manifold 10 and the mounting structure 20, as may contribute to improved thermal efficiency for the larger cooling system. In some cases, use of polymeric or other relatively soft materials can also aid in securing a spool bushing to the stud 12. For example, in some embodiments, the bore 140 can be tapped before installation along less than the full bore length 128 (e.g., only within a tapped region 126). The untapped portion of the bore 140 can act as a thread-lock as threads are formed within the untapped portion of the bore 140 as the bore 140 is threaded onto the stud 12. The formation of threads during installation along at least part of the bore 140 can help to better bond to the stud 12 to reduce the likelihood of unthreading. In some embodiments, the threaded region 126 of the bore 140 can be threaded along only about 70 percent of the bore length 128.

In some embodiments, a mounting protrusion can have a first portion with a major width (e.g., major diameter) and a second portion with a minor width (e.g., minor diameter) that is smaller than the major width. Further, the major width can be sized to be smaller than a characteristic dimension (e.g., lateral width or diameter) of a receiving portion of an aperture in a mounting structure (e.g., a keyhole slot), and larger than a characteristic dimension (e.g., lateral width or diameter) of a retention portion of the aperture, and the minor width can be sized to be smaller than the characteristic dimensions of the receiving and retention portions of the aperture.

Correspondingly, in some cases, a first portion (and major width) of a mounting protrusion can be received through a receiving portion of a slot on a mounting structure, to align a second portion (and minor width) of the mounting protrusion with side walls of a retention portion of the aperture. The mounting protrusion can then be slid along the aperture on the mounting structure, so that the narrower second portion of the mounting protrusion is received in the retention portion of the slot, and the wider first portion is aligned with the retention portion of the aperture to prevent the protrusion from being withdrawn out of the slot in an axial direction. With the protrusion then captured by an aperture in a retainer, to prevent movement back toward the receiving portion of the slot, the mounting protrusion can thus be relatively securely retained within the slot and thereby relatively securely attach the associated manifold to the mounting structure.

In this regard, for example, the spool bushing 118 has a groove 132 extending around the periphery of the spool bushing 118 to define a minor diameter for the distal end of the spool bushing 118 (i.e., a locally smallest width placed to be received into the aperture 108). The groove 132 has a proximal sidewall 134 and a distal sidewall 136. As shown, the distal sidewall 136 can be disposed at an oblique angle 138 away from the proximal sidewall 134 (see FIG. 7). The angle 138 of the distal sidewall 136 can aid in receiving the mounting structure 20 during the process of securing the manifold to the mounting structure 20 by encouraging the engagement and movement of the spool bushing 118 within the keyhole slot 22. For example, due to the angled configuration of the distal sidewall 136, initial contact between the walls of the keyhole slot and the distal sidewall 136 as the spool bushing 118 is moved into engagement with the keyhole slot 22 can cause the spool bushing 118 - and the manifold 10 - to be drawn into tighter engagement with the mounting structure 20.

Generally, other types of protrusions with circumferential (or other) grooves can be provided as mounting features, to operate similarly to the spool bushing 118 or other protruding mounting features disclosed herein. Further, in some cases, a spool or other structure may have a major width (e.g., diameter) and a minor width (e.g., diameter) that are generally similar to the configuration shown for the spool bushing 118, but with differently configured groove sidewalls.

In some embodiments, a locking feature (not shown) can be included on a retainer to affirmatively engage with a mounting (or other) structure and thereby secure the retainer in a particular (e.g., captured) orientation. For example, a snap-in tab (not shown) extending from the body 102 of the retainer 100 can be engaged with a reciprocal part of a snap-in tab assembly on the mounting structure 20. Such a locking feature can maintain the position of the retainer 100 relative to the mounting structure 20 when the spool bushing 118 is captured within the aperture 108. In some cases, this arrangement or others like it may reduce the likelihood of accidental or unintentional flexing of a retainer away from a mounting structure. The locking feature can also provide further tactile feedback of securing a manifold to a mounting structure after captivation of a relevant mounting feature.

In some implementations, devices or systems disclosed herein can be utilized or installed using methods embodying aspects of the invention. Correspondingly, description herein of particular features or capabilities of a device or system is generally intended to inherently include disclosure of a method of using such features for intended purposes and of implementing such capabilities. Similarly, express discussion of any method of using a particular device or system, unless otherwise indicated or limited, is intended to inherently include disclosure, as embodiments of the invention, of the utilized features and implemented capabilities of such device or system.

For example, with reference to FIGS 1-4, some embodiments can include a method by which a user can secure a connection between a manifold 10 and a mounting structure 20, using a retainer (e.g., the retainer 100) and a protrusion from the manifold 10 (e.g., the spool bushing 118). To secure the connection, a user can first align the manifold 10 with the mounting structure 20. The user can then insert the spool bushing 118 into the receiving portion 24 of the keyhole slot 22 in an axial insertion direction (e.g., aligned with a center axis of the spool bushing 118), as facilitated by the larger size of the receiving portion 24 of the keyhole slot 22 as compared to the major diameter (i.e., the locally widest width) of a distal end of the spool bushing 118. As received through the receiving portion 24, the spool bushing 118 can contact the retainer 100, located on the opposite side of the mounting structure 20, and thereby flex the retainer 100 away from the mounting structure 20 about the flex axis 116. The user can then move the manifold 10 (e.g., actively, or by allowing gravity to move the manifold 10) so that the spool bushing 118 translates within the keyhole slot 22 in a seating direction, from the receiving portion 24 to the retention portion 26, and side walls of the retention portion 26 of the slot 22 are received within the groove 132. As a result of this translational movement, the spool bushing 118 also moves relative to the retainer 100, and when the spool bushing 118 is appropriately within the retention portion 26 (e.g., seated at a bottom end thereof), the spool bushing 118 aligns with the aperture 108 and can be received therein as the retainer resiliently rebounds back toward the mounting structure. The aperture 108 correspondingly can capture the spool bushing 118 and thereby generally prevent movement of the manifold 10 relative to the mounting structure 20.

To release the manifold 10 from the mounting structure 20, a user can flex the retainer 100 away from the mounting structure 20 about the flex axis 116 to place the retainer 100 in a release configuration (e.g., as shown in FIGS, 1 and 2). As also noted above, some embodiments include a release tab (e.g., the tab 112) that a user can manually engage (e.g., push without the use of tools) to flex a retainer and thereby release a manifold, although other approaches are also possible.

Once the retainer 100 has been sufficiently flexed, the aperture 108 no longer captures the spool bushing 118 and the spool bushing 118 can be moved by the user from the retention portion 26 to the receiving portion 24 of the slot 22 (i.e., can be translated opposite the seating direction). The user can then remove the spool bushing 118 from the mounting structure 20 (i.e., opposite the axial insertion direction), thereby releasing the manifold from the mounting structure 20.

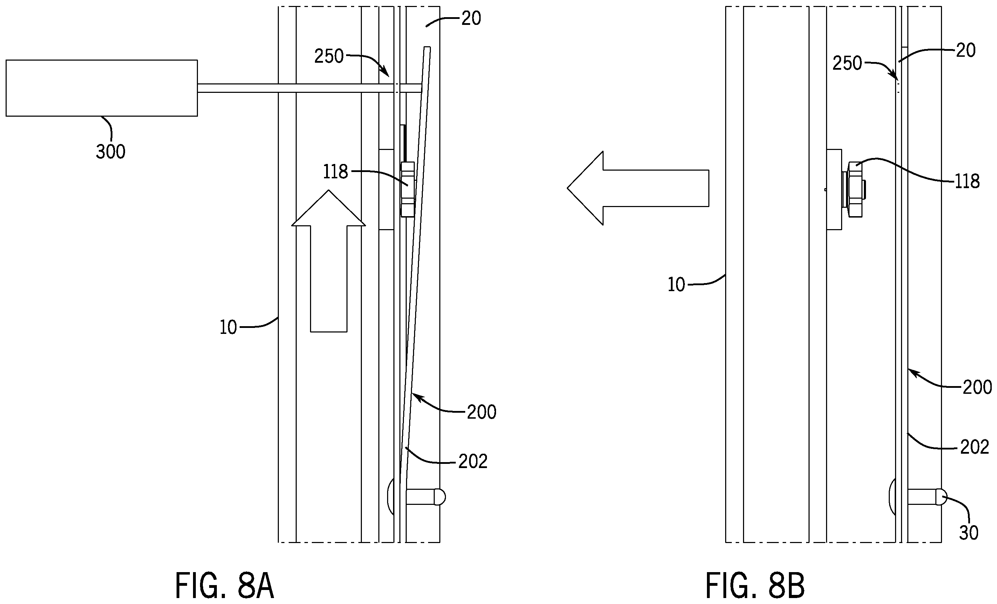

In some embodiments, other structures can be provided to allow a user to flex a retainer away from a mounting structure and thereby decapture a mounting feature. For example, as shown in FIGS. 8A and 8B, a method similar to the method discussed above can be used to mount or demount the manifold 10 relative to the mounting structure 20. In particular, as shown in FIG. 8A, a hand tool 300 (e.g., a screwdriver) can be inserted through a release aperture 250 in the mounting structure 20 to flex a free end of a body 202 of a retainer 200 away from the mounting structure 20 so that the bushing 118 (or another protrusion) can be decaptured by the retainer 200 and thereby released to be slid upward and then away from the mounting structure 20. Further, in the illustrated example, no release tab similar to the release tab 112 (see, e.g., s 1-4) is provided and the retainer 200 is arranged entirely on one side of the mounting structure 20, as may be beneficial for security and aesthetics in some installations.

Thus, embodiments of the invention can provide improved securement of the connection between a manifold and a mounting structure for shipping, installation, or while in use. In some embodiments, for example, a retainer can be affixed to the mounting structure and can be engaged during the connection of the manifold and mounting structure with no additional steps (e.g., with no direct engagement of the retainer by a user). The retainer can be configured to flex during the connection and rebound to capture a mounting feature that connects the manifold and the mounting structure.

The previous description of the disclosed embodiments is provided to enable any person skilled in the art to make or use the invention. Various modifications to these embodiments will be readily apparent to those skilled in the art, and the generic principles defined herein may be applied to other embodiments without departing from the scope of the invention. Thus, the invention is not intended to be limited to the embodiments shown herein but is to be accorded the widest scope consistent with the scope of the claims.

Features which are described in the context of separate embodiments may also be provided in combination in a single embodiment. Conversely, various features which are, for brevity, described in the context of a single embodiment, may also be provided separately or in any suitable sub-combination.

## Claims

1. A manifold system for a cooling system, the manifold system comprising:
a manifold (10) with a mounting protrusion;
a mounting structure (20) with a keyhole slot (22), with a receiving portion (24) of the keyhole slot being sized to receive the mounting protrusion and a retention portion (26) of the keyhole slot, in communication with the receiving portion (24) and narrower than the receiving portion (24); and
a retention plate (102) having a first end (106) and a second end (104) opposite the first end, the retention plate affixed to the mounting structure at the second end to define a flex axis (116), the retention plate being flexible at the flex axis (116) to flex between a retention configuration and a release configuration, with the second end (104) of the retention plate being farther from the mounting structure (20) in the release configuration than in the retention configuration;
the retention plate (102) having an aperture (108) in the first end (106), the aperture (108) being positioned to overlap with the retention portion (26) of the keyhole slot; and
the retention plate (102) being configured to:
flex away from the mounting structure (20) to the release configuration upon contact with the mounting protrusion, when the mounting protrusion is received through the receiving portion (24) of the keyhole slot; and
rebound toward the mounting structure (20) to the retention configuration when the mounting protrusion is received within the retention portion (26) of the keyhole slot, to capture the mounting protrusion in the aperture (108) and the retention portion (26) to secure the manifold (10) to the mounting structure (20);
wherein the mounting protrusion is a bushing (118) having a major diameter and a groove (132) with a minor diameter, the bushing (118) extending along a bushing axis (130) and being secured to the manifold (10) to extend away from the manifold to be received through the keyhole slot (22), the major diameter being sized to be received in the receiving portion (24) of the keyhole slot but not in the retention portion (26) of the keyhole slot (22), and the minor diameter being sized to be received in the receiving and retention portions (24, 26) of the keyhole slot (22);
the retention plate (102) configured to be deflected away from the mounting structure upon contact with the bushing, when the bushing extends through the first portion of the slot, and to rebound to receive the bushing within the aperture and thereby capture the bushing within the slot when the groove of the bushing is slid into the second portion of the slot; and,
wherein the groove of the bushing (118) comprises a proximal sidewall (134) and a distal sidewall (136), the distal sidewall disposed at an oblique angle (138) relative to the proximal sidewall.

2. The manifold system of claim 1, wherein the retention plate (102) is flush with and parallel to the mounting structure (20), on an opposite side of the mounting structure from the manifold (10), when the retention plate is in the retention configuration to capture the mounting protrusion in the keyhole slot (22).

3. The manifold system of either of claims 1 or 2, further comprising:
a release tab (112) extending from the retention plate (102) through the mounting structure (20) toward the manifold (10), the release tab (112) being placed to be urged toward the mounting structure (20) to flex the retention plate (102) to the release configuration.

4. The manifold system of claim 3, wherein the release tab (112) extends as a bent component with a free end (124) configured to contact the mounting structure when the retention plate (102) has flexed a predetermined distance, and optionally or preferably wherein the release tab is integral with the retention plate (102).

5. The manifold system of any of the preceding claims, wherein the first end (106) of the retention plate (102) has a first-end width (122) measured along a direction of the flex axis (116);
wherein the first end of the retention plate further includes a notch with a notch width (120) measured along the direction of the flex axis (116).

6. The manifold system of claim 5, wherein the notch width (120) is in a range of about 25 percent to about 75 percent of the first-end width (122).

7. The manifold system of any of the preceding claims, wherein a first part of the retention plate (102) that does not include the aperture (108) is aligned with the receiving portion (24) of the keyhole slot (22) when the retention plate (102) is in the retention configuration.

8. The manifold system of claim 7, wherein the mounting structure (20) includes a release aperture (28); and
wherein a second part of the retention plate (102) that does not include the aperture (108) at least partly overlaps with the release aperture (28) so that the retention plate (102) is arranged to be flexed to the release configuration by contact with a tool inserted through the release aperture (28).

9. The manifold system of claim 1, wherein the bushing (118) is a polymeric bushing and includes a bore (140) that is configured to receive a threaded stud of the manifold; and
wherein the bore of the bushing has a bore length and is threaded along a first portion (126) of the bore length and not threaded along a second portion of the bore length

10. The manifold system of claim 10, wherein the first portion (126) extends about 70 percent of the bore length.

11. A method for mounting or demounting a manifold, the method comprising:
aligning a manifold assembly (10) with a mounting structure (20);
moving the manifold assembly (10) toward the mounting structure (20) to insert a mounting protrusion of the manifold assembly in an axial insertion direction into a receiving portion (24) of a keyhole slot (22) on the mounting structure (20), whereby the mounting protrusion extends through the keyhole slot (22) to contact a retainer (100) that is secured to the mounting structure (20) at a first end (106) of the retainer and flexes the retainer to deflect a second end (104) of the retainer away from the mounting structure (20); and
moving the manifold assembly (10) along the mounting structure (20) in a seating direction to move the mounting protrusion from the receiving portion (24) of the keyhole slot (22) into a retention portion (26) of the keyhole slot (22) that prevents movement of the mounting protrusion out of the keyhole slot (22) in a direction opposite the axial insertion direction, whereby the retainer (100) resiliently unflexes to move the second end (104) of the retainer toward the mounting structure (20) so that the mounting protrusion is received in an aperture (108) in the first end of the retainer (100) that is aligned with the retention portion (26) of the keyhole slot (22) and the mounting protrusion is thereby captured in the aperture (108) and the retention portion (26) of the keyhole slot (22) against movement in a direction opposite the seating direction.
wherein the mounting protrusion is a bushing (118) having a major diameter and a groove (132) with a minor diameter, the bushing (118) extending along a bushing axis (130) and being secured to the manifold (10) to extend away from the manifold to be received through the keyhole slot (22), the major diameter being sized to be received in the receiving portion (24) of the keyhole slot (22) but not in the retention portion (26) of the keyhole slot (22), and the minor diameter being sized to be received in the receiving and retention portions (24, 26) of the keyhole slot (22);
the retention plate (102) configured to be deflected away from the mounting structure upon contact with the bushing (118), when the bushing (118) extends through the first portion of the slot, and to rebound to receive the bushing (118) within the aperture and thereby capture the bushing (118) within the slot when the groove of the bushing is slid into the second portion of the slot; and,
wherein the groove of the bushing (118) comprises a proximal sidewall (134) and a distal sidewall (136), the distal sidewall disposed at an oblique angle (138) relative to the proximal sidewall.

12. The method of claim 11, further comprising:
with the mounting protrusion (12) retained in the retention portion (26) of the keyhole slot, manually engaging the retainer (100) to deflect the second end (104) of the retainer away from the mounting structure (20) and thereby remove the mounting protrusion (12) from the aperture (108);
with the second end (104) of the retainer deflected away from the mounting structure (20), moving the manifold assembly (10) along the mounting structure (20) in the direction opposite the seating direction to move the mounting protrusion (12) to the receiving portion (24) of the keyhole slot; and
moving the manifold assembly (10) away from the mounting structure (20), in the direction opposite the axial insertion direction, to remove the mounting protrusion (12) from the keyhole slot (22).

13. The method of claim 12, wherein manually engaging the retainer (100) to deflect the second end (104) includes extending a tool (300) through a release aperture (250) in the mounting structure (20).

## Patentansprüche

1. Verteilersystem für ein Kühlsystem, wobei das Verteilersystem Folgendes umfasst:
einen Verteiler (10) mit einem Montagevorsprung;
eine Montagestruktur (20) mit einem Schlüssellochschlitz (22), wobei ein Aufnahmeabschnitt (24) des Schlüssellochschlitzes bemessen ist, um den Montagevorsprung und einen Halteabschnitt (26) des Schlüssellochschlitzes in Kommunikation mit dem Aufnahmeabschnitt (24) aufzunehmen, und schmaler als der Aufnahmeabschnitt (24) ist; und
eine Halteplatte (102), die ein erstes Ende (106) und ein zweites Ende (104) gegenüber dem ersten Ende aufweist, wobei die Halteplatte an dem zweiten Ende an der Montagestruktur befestigt ist, um eine Biegeachse (116) zu definieren, wobei die Halteplatte an der Biegeachse (116) biegbar ist, um sich zwischen einer Haltekonfiguration und einer Freigabekonfiguration zu biegen, wobei das zweite Ende (104) der Halteplatte in der Freigabekonfiguration weiter von der Montagestruktur (20) als in der Haltekonfiguration entfernt ist;
wobei die Halteplatte (102) eine Öffnung (108) in dem ersten Ende (106) aufweist, wobei die Öffnung (108) positioniert ist, um sich mit dem Halteabschnitt (26) des Schlüssellochschlitzes zu überlappen; und
wobei die Halteplatte (102) dazu konfiguriert ist:
sich bei Kontakt mit dem Montagevorsprung weg von der Montagestruktur (20) zu der Freigabekonfiguration zu biegen, wenn der Montagevorsprung über den Aufnahmeabschnitt (24) des Schlüssellochschlitzes aufgenommen ist; und
in Richtung der Montagestruktur (20) in die Haltekonfiguration zurückzuspringen, wenn der Montagevorsprung innerhalb des Halteabschnitts (26) des Schlüssellochschlitzes aufgenommen ist, um den Montagevorsprung in der Öffnung (108) und den Halteabschnitt (26) zu erfassen, um den Verteiler (10) an der Montagestruktur (20) zu sichern;
wobei der Montagevorsprung eine Buchse (118) ist, die einen großen Durchmesser und eine Nut (132) mit einem kleinen Durchmesser aufweist, wobei sich die Buchse (118) entlang einer Buchsenachse (130) erstreckt und an dem Verteiler (10) gesichert ist, um sich von dem Verteiler weg zu erstrecken, um über den Schlüssellochschlitz (22) aufgenommen zu werden, wobei der große Durchmesser bemessen ist, um in dem Aufnahmeabschnitt (24) des Schlüssellochschlitzes, aber nicht in dem Halteabschnitt (26) des Schlüssellochschlitzes (22) aufgenommen zu werden, und der kleine Durchmesser bemessen ist, um in den Aufnahme- und den Halteabschnitt (24, 26) des Schlüssellochschlitzes (22) aufgenommen zu werden;
die Halteplatte (102) dazu konfiguriert ist, bei Kontakt mit der Buchse von der Montagestruktur weg abgelenkt zu werden, wenn sich die Buchse über den ersten Abschnitt des Schlitzes erstreckt, und zurückzuspringen, um die Buchse innerhalb der Öffnung aufzunehmen und dadurch die Buchse innerhalb des Schlitzes zu erfassen, wenn die Nut der Buchse in den zweiten Abschnitt des Schlitzes eingeschoben wird; und
wobei die Nut der Buchse (118) eine proximale Seitenwand (134) und eine distale Seitenwand (136) umfasst, die distale Seitenwand in einem schrägen Winkel (138) relativ zu der proximalen Seitenwand angeordnet ist.

2. Verteilersystem nach Anspruch 1, wobei die Halteplatte (102) bündig mit und parallel zu der Montagestruktur (20) auf einer dem Verteiler (10) gegenüberliegenden Seite der Montagestruktur ist, wenn sich die Halteplatte in der Haltekonfiguration befindet, um den Montagevorsprung in dem Schlüssellochschlitz (22) zu erfassen.

3. Verteilersystem nach einem der Ansprüche 1 oder 2, ferner umfassend:
eine Freigabelasche (112), die sich von der Halteplatte (102) über die Montagestruktur (20) in Richtung des Verteilers (10) erstreckt, wobei die Freigabelasche (112) platziert ist, um in Richtung der Montagestruktur (20) gedrückt zu werden, um die Halteplatte (102) in die Freigabekonfiguration zu biegen.

4. Verteilersystem nach Anspruch 3, wobei sich die Freigabelasche (112) als gebogene Komponente mit einem freien Ende (124) erstreckt, das dazu konfiguriert ist, die Montagestruktur zu kontaktieren, wenn sich die Halteplatte (102) um einen vorbestimmten Abstand gebogen hat, und wobei die Freigabelasche optional oder bevorzugt einstückig mit der Halteplatte (102) ausgebildet ist.

5. Verteilersystem nach einem der vorhergehenden Ansprüche, wobei das erste Ende (106) der Halteplatte (102) eine Breite (122) am ersten Ende aufweist, die entlang einer Richtung der Biegeachse (116) gemessen wird;
wobei das erste Ende der Halteplatte ferner eine Kerbe mit einer Kerbenbreite (120) beinhaltet, die entlang der Richtung der Biegeachse (116) gemessen wird.

6. Verteilersystem nach Anspruch 5, wobei die Kerbenbreite (120) in einem Bereich von etwa 25 Prozent bis etwa 75 Prozent der Breite (122) am ersten Ende liegt.

7. Verteilersystem nach einem der vorhergehenden Ansprüche, wobei ein erster Teil der Halteplatte (102), der die Öffnung (108) nicht beinhaltet, mit dem Aufnahmeabschnitt (24) des Schlüssellochschlitzes (22) ausgerichtet ist, wenn sich die Halteplatte (102) in der Haltekonfiguration befindet.

8. Verteilersystem nach Anspruch 7, wobei die Montagestruktur (20) eine Freigabeöffnung (28) beinhaltet; und
wobei sich ein zweiter Teil der Halteplatte (102), der nicht die Öffnung (108) beinhaltet, mindestens teilweise mit der Freigabeöffnung (28) überlappt, sodass die Halteplatte (102) angeordnet ist, um durch Kontakt mit einem Werkzeug, das über die Freigabeöffnung (28) eingeführt ist, in die Freigabekonfiguration gebogen zu werden.

9. Verteilersystem nach Anspruch 1, wobei die Buchse (118) eine Polymerbuchse ist und eine Bohrung (140) beinhaltet, die dazu konfiguriert ist, einen Gewindebolzen des Verteilers aufzunehmen; und
wobei die Bohrung der Buchse eine Bohrungslänge aufweist und entlang eines ersten Abschnitts (126) der Bohrungslänge mit einem Gewinde versehen ist und entlang eines zweiten Abschnitts der Bohrungslänge nicht mit einem Gewinde versehen ist.

10. Verteilersystem nach Anspruch 10, wobei sich der erste Abschnitt (126) um etwa 70 Prozent der Bohrungslänge erstreckt.

11. Verfahren zum Montieren oder Demontieren eines Verteilers, wobei das Verfahren Folgendes umfasst:
Ausrichten einer Verteilerbaugruppe (10) mit einer Montagestruktur (20);
Bewegen der Verteilerbaugruppe (10) in Richtung der Montagestruktur (20), um einen Montagevorsprung der Verteilerbaugruppe in einer axialen Einführungsrichtung in einen Aufnahmeabschnitt (24) eines Schlüssellochschlitzes (22) an der Montagestruktur (20) einzuführen, wobei sich der Montagevorsprung über den Schlüssellochschlitz (22) erstreckt, um eine Halterung (100) zu kontaktieren, die an einem ersten Ende (106) der Halterung an der Montagestruktur (20) befestigt ist, und die Halterung biegt, um ein zweites Ende (104) der Halterung von der Montagestruktur (20) weg abzulenken; und
Bewegen der Verteilerbaugruppe (10) entlang der Montagestruktur (20) in einer Sitzrichtung, um den Montagevorsprung von dem Aufnahmeabschnitt (24) des Schlüssellochschlitzes (22) in einen Halteabschnitt (26) des Schlüssellochschlitzes (22) zu bewegen, der eine Bewegung des Montagevorsprungs aus dem Schlüssellochschlitz (22) in einer Richtung entgegengesetzt zu der axialen Einführungsrichtung verhindert, wobei sich die Halterung (100) federnd nicht biegt, um das zweite Ende (104) der Halterung in Richtung der Montagestruktur (20) zu bewegen, sodass der Montagevorsprung in einer Öffnung (108) in dem ersten Ende der Halterung (100) aufgenommen ist, die mit dem Halteabschnitt (26) des Schlüssellochschlitzes (22) ausgerichtet ist, und der Montagevorsprung dadurch in der Öffnung (108) und dem Halteabschnitt (26) des Schlüssellochschlitzes (22) gegen eine Bewegung in einer Richtung entgegen der Sitzrichtung erfasst wird.
wobei der Montagevorsprung eine Buchse (118) ist, die einen großen Durchmesser und eine Nut (132) mit einem kleinen Durchmesser aufweist, wobei sich die Buchse (118) entlang einer Buchsenachse (130) erstreckt und an dem Verteiler (10) gesichert ist, um sich von dem Verteiler weg zu erstrecken, um über den Schlüssellochschlitz (22) aufgenommen zu werden, wobei der große Durchmesser bemessen ist, um in dem Aufnahmeabschnitt (24) des Schlüssellochschlitzes (22), aber nicht in dem Halteabschnitt (26) des Schlüssellochschlitzes (22) aufgenommen zu werden, und der kleine Durchmesser bemessen ist, um in den Aufnahme- und den Halteabschnitt (24, 26) des Schlüssellochschlitzes (22) aufgenommen zu werden;
die Halteplatte (102) dazu konfiguriert ist, bei Kontakt mit der Buchse (118) von der Montagestruktur weg abgelenkt zu werden, wenn sich die Buchse (118) über den ersten Abschnitt des Schlitzes erstreckt, und zurückzuspringen, um die Buchse (118) innerhalb der Öffnung aufzunehmen und dadurch die Buchse (118) innerhalb des Schlitzes zu erfassen, wenn die Nut der Buchse in den zweiten Abschnitt des Schlitzes eingeschoben wird; und
wobei die Nut der Buchse (118) eine proximale Seitenwand (134) und eine distale Seitenwand (136) umfasst, die distale Seitenwand in einem schrägen Winkel (138) relativ zu der proximalen Seitenwand angeordnet ist.

12. Verfahren nach Anspruch 11, ferner umfassend:
manuelles Ineingriffnehmen der Halterung (100), um das zweite Ende (104) der Halterung weg von der Montagestruktur (20) abzulenken und dadurch den Montagevorsprung (12) von der Öffnung (108) zu entfernen, wobei der Montagevorsprung (12) in dem Halteabschnitt (26) des Schlüssellochschlitzes gehalten wird;
Bewegen der Verteilerbaugruppe (10) entlang der Montagestruktur (20) in der Richtung entgegen der Sitzrichtung, um den Montagevorsprung (12) zu dem Aufnahmeabschnitt (24) des Schlüssellochschlitzes zu bewegen, wobei das zweite Ende (104) der Halterung von der Montagestruktur (20) weg abgelenkt wird; und
Bewegen der Verteilerbaugruppe (10) weg von der Montagestruktur (20) in die Richtung entgegen der axialen Einführungsrichtung, um den Montagevorsprung (12) aus dem Schlüssellochschlitz (22) zu entfernen.

13. Verfahren nach Anspruch 12, wobei das manuelle Ineingriffnehmen der Halterung (100), um das zweite Ende (104) abzulenken, das Erstrecken eines Werkzeugs (300) über eine Freigabeöffnung (250) in der Montagestruktur (20) beinhaltet.

## Revendications

1. Système de collecteur pour un système de refroidissement, le système de collecteur comprenant :
un collecteur (10) doté d'une saillie de montage ;
une structure de montage (20) dotée d'une fente en trou de serrure (22), une partie de réception (24) de la fente en trou de serrure étant dimensionnée pour recevoir la saillie de montage et une partie de retenue (26) de la fente en trou de serrure, en communication avec la partie de réception (24) et plus étroite que la partie de réception (24) ; et
une plaque de retenue (102) présentant une première extrémité (106) et une seconde extrémité (104) opposée à la première extrémité, la plaque de retenue étant fixée à la structure de montage au niveau de la seconde extrémité pour définir un axe de flexion (116), la plaque de retenue étant flexible au niveau de l'axe de flexion (116) pour fléchir entre une configuration de retenue et une configuration de libération, la seconde extrémité (104) de la plaque de retenue étant plus éloignée de la structure de montage (20) dans la configuration de libération que dans la configuration de retenue ;
la plaque de retenue (102) présentant une ouverture (108) dans la première extrémité (106), l'ouverture (108) étant positionnée pour chevaucher la partie de retenue (26) de la fente en trou de serrure ; et
la plaque de retenue (102) étant configurée pour :
s'écarter par flexion de la structure de montage (20) vers la configuration de libération lors du contact avec la saillie de montage, lorsque la saillie de montage est reçue à travers la partie de réception (24) de la fente en trou de serrure ; et
revenir élastiquement en direction de la structure de montage (20) vers la configuration de retenue lorsque la saillie de montage est reçue à l'intérieur de la partie de retenue (26) de la fente en trou de serrure, pour capturer la saillie de montage dans l'ouverture (108) et la partie de retenue (26) afin de fixer le collecteur (10) à la structure de montage (20) ;
dans lequel la saillie de montage est une douille (118) présentant un grand diamètre et une rainure (132) présentant un petit diamètre, la douille (118) s'étendant le long d'un axe de douille (130) et étant fixée au collecteur (10) pour s'étendre à l'opposé du collecteur afin d'être reçue à travers la fente en trou de serrure (22), le grand diamètre étant dimensionné pour être reçu dans la partie de réception (24) de la fente en trou de serrure mais pas dans la partie de retenue (26) de la fente en trou de serrure (22), et le petit diamètre étant dimensionné pour être reçu dans les parties de réception et de retenue (24, 26) de la fente en trou de serrure (22) ;
la plaque de retenue (102) étant configurée pour être déviée à l'opposé de la structure de montage lors du contact avec la douille, lorsque la douille s'étend à travers la première partie de la fente, et pour revenir élastiquement afin de recevoir la douille à l'intérieur de l'ouverture et capturer ainsi la douille à l'intérieur de la fente lorsque la rainure de la douille est glissée dans la seconde partie de la fente ; et
dans lequel la rainure de la douille (118) comprend une paroi latérale proximale (134) et une paroi latérale distale (136), la paroi latérale distale étant disposée selon un angle oblique (138) par rapport à la paroi latérale proximale.

2. Système de collecteur selon la revendication 1, dans lequel la plaque de retenue (102) est affleurante et parallèle à la structure de montage (20), sur un côté opposé de la structure de montage par rapport au collecteur (10), lorsque la plaque de retenue est dans la configuration de retenue pour capturer la saillie de montage dans la fente en trou de serrure (22).

3. Système de collecteur selon l'une quelconque des revendications 1 et 2, comprenant en outre :
une languette de libération (112) s'étendant depuis la plaque de retenue (102) à travers la structure de montage (20) vers le collecteur (10), la languette de libération (112) étant placée pour être poussée vers la structure de montage (20) afin de faire fléchir la plaque de retenue (102) vers la configuration de libération.

4. Système de collecteur selon la revendication 3, dans lequel la languette de libération (112) s'étend sous la forme d'un composant coudé doté d'une extrémité libre (124) configurée pour venir en contact avec la structure de montage lorsque la plaque de retenue (102) a fléchi d'une distance prédéterminée, et, éventuellement ou de préférence, dans lequel la languette de libération fait partie intégrante de la plaque de retenue (102).

5. Système de collecteur selon l'une quelconque des revendications précédentes, dans lequel la première extrémité (106) de la plaque de retenue (102) présente une largeur de première extrémité (122) mesurée dans la direction de l'axe de flexion (116) ;
dans lequel la première extrémité de la plaque de retenue comprend en outre une encoche présentant une largeur d'encoche (120) mesurée dans la direction de l'axe de flexion (116).

6. Système de collecteur selon la revendication 5, dans lequel la largeur d'encoche (120) est comprise dans une plage allant d'environ 25 pour cent à environ 75 pour cent de la largeur de première extrémité (122).

7. Système de collecteur selon l'une quelconque des revendications précédentes, dans lequel une première partie de la plaque de retenue (102) qui ne comprend pas l'ouverture (108) est alignée avec la partie de réception (24) de la fente en trou de serrure (22) lorsque la plaque de retenue (102) est dans la configuration de retenue.

8. Système de collecteur selon la revendication 7, dans lequel la structure de montage (20) comprend une ouverture de libération (28) ; et
dans lequel une seconde partie de la plaque de retenue (102) qui ne comprend pas l'ouverture (108) chevauche au moins partiellement l'ouverture de libération (28) de sorte que la plaque de retenue (102) est agencée pour fléchir vers la configuration de libération par contact avec un outil inséré à travers l'ouverture de libération (28).

9. Système de collecteur selon la revendication 1, dans lequel la douille (118) est une douille polymère et comprend un alésage (140) qui est configuré pour recevoir un goujon fileté du collecteur ; et
dans lequel l'alésage de la douille présente une longueur d'alésage et est fileté le long d'une première partie (126) de la longueur d'alésage et non fileté le long d'une seconde partie de la longueur d'alésage.

10. Système de collecteur selon la revendication 10, dans lequel la première partie (126) s'étend sur environ 70 pour cent de la longueur d'alésage.

11. Procédé de montage ou de démontage d'un collecteur, le procédé comprenant les étapes consistant à :
aligner un ensemble collecteur (10) avec une structure de montage (20) ;
déplacer l'ensemble collecteur (10) vers la structure de montage (20) pour insérer une saillie de montage de l'ensemble collecteur dans une direction d'insertion axiale dans une partie de réception (24) d'une fente en trou de serrure (22) sur la structure de montage (20), moyennant quoi la saillie de montage s'étend à travers la fente en trou de serrure (22) pour venir en contact avec un dispositif de retenue (100) qui est fixé à la structure de montage (20) au niveau d'une première extrémité (106) du dispositif de retenue et fait fléchir le dispositif de retenue pour dévier une seconde extrémité (104) du dispositif de retenue à l'opposé de la structure de montage (20) ; et
déplacer l'ensemble collecteur (10) le long de la structure de montage (20) dans une direction de mise en place pour déplacer la saillie de montage de la partie de réception (24) de la fente en trou de serrure (22) dans une partie de retenue (26) de la fente en trou de serrure (22) qui empêche le mouvement de la saillie de montage hors de la fente en trou de serrure (22) dans une direction opposée à la direction d'insertion axiale, moyennant quoi le dispositif de retenue (100) se détend par élasticité pour déplacer la seconde extrémité (104) du dispositif de retenue vers la structure de montage (20) de sorte que la saillie de montage est reçue dans une ouverture (108) dans la première extrémité du dispositif de retenue (100) qui est alignée avec la partie de retenue (26) de la fente en trou de serrure (22) et la saillie de montage est ainsi capturée dans l'ouverture (108) et la partie de retenue (26) de la fente en trou de serrure (22) pour s'opposer à un mouvement dans une direction opposée à la direction de mise en place,
dans lequel la saillie de montage est une douille (118) présentant un grand diamètre et une rainure (132) présentant un petit diamètre, la douille (118) s'étendant le long d'un axe de douille (130) et étant fixée au collecteur (10) pour s'étendre à l'opposé du collecteur afin d'être reçue à travers la fente en trou de serrure (22), le grand diamètre étant dimensionné pour être reçu dans la partie de réception (24) de la fente en trou de serrure (22) mais pas dans la partie de retenue (26) de la fente en trou de serrure (22), et le petit diamètre étant dimensionné pour être reçu dans les parties de réception et de retenue (24, 26) de la fente en trou de serrure (22) ;
la plaque de retenue (102) étant configurée pour être déviée à l'opposé de la structure de montage lors du contact avec la douille (118), lorsque la douille (118) s'étend à travers la première partie de la fente, et pour revenir élastiquement afin de recevoir la douille (118) à l'intérieur de l'ouverture et capturer ainsi la douille (118) à l'intérieur de la fente lorsque la rainure de la douille est glissée dans la seconde partie de la fente ; et
dans lequel la rainure de la douille (118) comprend une paroi latérale proximale (134) et une paroi latérale distale (136), la paroi latérale distale étant disposée selon un angle oblique (138) par rapport à la paroi latérale proximale.

12. Procédé selon la revendication 11, comprenant en outre les étapes consistant à :
avec la saillie de montage (12) retenue dans la partie de retenue (26) de la fente en trou de serrure, solliciter manuellement le dispositif de retenue (100) pour dévier la seconde extrémité (104) du dispositif de retenue à l'opposé de la structure de montage (20) et retirer ainsi la saillie de montage (12) de l'ouverture (108) ;
avec la seconde extrémité (104) du dispositif de retenue déviée à l'opposé de la structure de montage (20), déplacer l'ensemble collecteur (10) le long de la structure de montage (20) dans la direction opposée à la direction de mise en place pour déplacer la saillie de montage (12) vers la partie de réception (24) de la fente en trou de serrure ; et
déplacer l'ensemble collecteur (10) à l'écart de la structure de montage (20), dans la direction opposée à la direction d'insertion axiale, pour retirer la saillie de montage (12) de la fente en trou de serrure (22).

13. Procédé selon la revendication 12, dans lequel la sollicitation manuelle du dispositif de retenue (100) pour dévier la seconde extrémité (104) comprend l'extension d'un outil (300) à travers une ouverture de libération (250) dans la structure de montage (20).
